(19) Europäisches Patentamt
European Patent Office
Office européen des brevets

(11) Numéro de publication: **0 213 010**
**B1**

(12) **FASCICULE DE BREVET EUROPEEN**

(45) Date de publication du fascicule du brevet: **26.09.90**

(21) Numéro de dépôt: **86401568.0**

(22) Date de dépôt: **15.07.86**

(51) Int. Cl.$^5$: **C 04 B 35/18,** C 01 B 33/26 // H01B3/12

(54) **Procédé de préparation d'une poudre céramique de type cordierite frittable à basse température, poudre obtenue par le procédé et composition céramique obtenue par frittage de cette poudre.**

(30) Priorité: **16.07.85 FR 8510873**

(43) Date de publication de la demande:
**04.03.87 Bulletin 87/10**

(45) Mention de la délivrance du brevet:
**26.09.90 Bulletin 90/39**

(84) Etats contractants désignés:
**AT BE CH DE FR GB IT LI LU NL SE**

(56) Documents cités:
**EP-A-0 132 740**
**GB-A-2 119 356**
**US-A-4 367 292**
**CHEMICAL ABSTRACTS, vol. 102, no. 14, avril 1985, page 311, résumé no. 118404n, Columbus, Ohio, US; & JP-A-59 203 767 (TOYOTA CENTRAL RESEARCH AND DEVELOPMENT LABORATORIES INC.) 17-11-1984**
**JOURNAL OF NON-CRYSTALLINE SOLIDS, vol. 63, no. 1/2, février 1984, pages 81-93, Elsevier Science Publishers B.V. (North-Holland Physics Publishing Division), Amsterdam, NL; F. PANCRAZI et al.: "Preparation of gels in the CaO-Al2O3-SiO2 system from metal alkoxides"**

(73) Titulaire: **Etablissement Public dit: CENTRE NATIONAL DE LA RECHERCHE SCIENTIFIQUE (CNRS)**
**15, Quai Anatole France**
**F-75007 Paris (FR)**

(72) Inventeur: **Bernier, Jean-Claude**
**11, rue de la Lorraine**
**67380 Lingolsheim (FR)**
Inventeur: **Poix, Paul**
**61, rue de la Lorraine**
**67380 Lingolsheim (FR)**
Inventeur: **Rehspringer, Jean-Luc**
**194, rue de Altdorf**
**67210 Griesheim près Molsheim (FR)**
Inventeur: **Vilmin, Gabriel ECOLE SUPERIEURE DES HAUTES ETUDES**
**Dépt. Sciences des Matériaux 1, rue Blaise Pascal**
**B.P. 296 R8 F-67008 Strasbourg Cédex (FR)**
Inventeur: **Vilminot, Serge**
**6, avenue du Général de Gaulle**
**67000 Strasbourg (FR)**

(74) Mandataire: **Schrimpf, Robert et al**
**Cabinet Regimbeau 26, Avenue Kléber**
**F-75116 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

EP 0 213 010 B1

**Description**

La présente invention a été faite du Département Sciences des Matériaux de l'Ecole Nationale Supérieure de Chimie de Strasbourg, Unité associée au Centre National de la Recherche Scientifique N° 440.

Elle à trait à un procédé de préparation d'une poudre céramique frittable de type cordiérite (2 MgO, 2 $Al_2O_3$, 5 $SiO_2$), présentant une excellente aptitude au frittage, ainsi qù à la poudre ainsi obtenue.

On entendra par composition "de type cordiérite" une composition comprise dans le domaine 60 à 50% $SiO_2$, 5 à 20% MgO et 20 à 40% $Al_2O_3$ du diagramme ternaire $SiO_2$—MgO—$Al_2O_3$ (ici et dans la suite, sauf indication contraire, toutes les proportions indiquées seront des proportions pondérales).

L'invention concerne également de nouvelles compositions céramiques obtenues par frittage desdites poudres, se caractérisant par une densité très proche de la densité théorique de la cordiérite et par une constante diélectrique faible (inférieure à 5).

Il est connu depuis de nombreuses années déjà d'utiliser des céramiques à base de cordiérite pour de nombreuses applications, notamment la fabrication de substrats isolants et de supports pour les circuits intégrés. Ces céramiques sont préparées par frittage d'une poudre de composition proche de la cordiérite à une température de l'ordre de 1350°C et après addition d'agents de frittage tels que $P_2O_5$. De telles céramiques sont par exemple décrites par K. Watanabe et E. Giess dans J. Am. Ceram. Soc. *68* 4 C-102—C-103 (1985).

Les poudres céramiques frittables de type cordiérite obtenues selon l'invention présentent l'avantage sur les poudres antérieurement utilisées pour préparer les céramiques à base de cordiérite, de fritter à des températures beaucoup plus basses, inférieures à 1100°C et même à 950°C, et sans qu'il soit besoin d'ajouter des agents de frittage.

Le procédé conforme à l'invention est caractérisé en ce qu'il consiste successivement:

. à préparer une solution alcoolique mixte de sels de magnésium, d'aluminium et de silicium, lesdits sels devant être solubles dans l'alcool ou dans un solvant miscible avec l'alcool,

. à réaliser une agitation vigoureuse pour obtenir une solution homogène,

. à ajouter à la solution précédente un agent hydrolysant sous forme de base faible totalement volatile, ce qui conduit à la formation d'un gel,

. à traiter thermiquement le gel obtenu à une température qu plus égale à 450°C pendant une durée au plus égale à 24 h, ce qui conduit à la formation d'une poudre, et

. à traiter thermiquement la poudre obtenue à une température comprise entre 450°C et 900°C pendant une durée au plus égale à 6 h.

De préférence, l'étape de traitement thermique de la poudre est précédée d'une étape de traitement par de l'eau oxygénée à une température comprise entre 60°C et 100°C, puis de filtrage de la suspension obtenue.

L'aluminium est introduit:

—soit sous forme d'un alcoxyde soluble dans l'alcool de formule

$$Al[O(CH_2)_nCH_3]_3$$

dans laquelle n représente en nombre entier compris entre 0 et 4.

On utilise avantageusement le butoxyde d'aluminium de formule

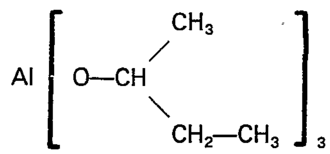

Mais d'autres alcoxydes conduisent également à de bons résultats, tels que l'éthoxyde, le propoxyde et l'isopropoxyde d'aluminium:

—soit sous forme de sels organiques ou complexes organiques, tels que l'acétate d'aluminium, le benzoate d'aluminium, l'acétylacétonate d'aluminium, le stéarate d'aluminium.

D'une façon générale, tous les sels ou complexes organiques solubles dans l'alcool ou solubles dans un solvant miscible avec l'alcool conviennent à la réalisation de l'invention:

—soit encore sous forme de sels minéraux, tels que le nitrate d'aluminium Al $(NO_3)_3$ hydraté ou non en solution alcoolique, le chlorure d'aluminium Al $Cl_3$ en solution alcoolique; en portant cette dernière solution à l'ébullition pendant un temps suffisant, on élimine l'acide chlorhydrique et on génère l'alcoxyde d'aluminium correspondant. Le chlorure d'aluminium hydraté peut également être utilisé.

D'une façon générale, tous les sels d'aluminium solubles dans l'alcool ou dans un solvant miscible avec l'alcool conviennent à la réalisation de l'invention.

Le silicium est introduit:

—soit sous la forme d'un alcoxyde soluble dans l'alcool de formule

$$Si[O(CH_2)_nCH_3]_4$$

dans laquelle n représente un nombre entier compris entre 0 et 4.

On utilise avantageusement l'éthoxyde de silicium de formule

$$Si[OC_2H_5]_4$$

Mais d'autres alcoxydes de silicium conduisent également à de bons résultats, tels que le méthoxyde, le propoxyde, l'isopropoxyde et le butoxyde de silicium:

—soit sous forme d'esters ou de sels, tels que le tétracétate de silicium $(CH_3—COO)_4$ Si soluble dans l'acide acétique, ou encore un silicate d'ammonium quaternaire.

D'une façon générale, tous les esters ou sels solubles dans l'alcool ou solubles dans un solvant miscible avec l'alcool, ou encore dans leur acide correspondant conviennent à la réalisation de l'invention.

Le magnésium est introduit:

—soit sous forme d'un ester ou d'un sel.

On utilise avantageusement l'acétate de magnésium Mg $(CH_3COO)_2$ hydraté ou non dans de l'acide acétique anhydre.

D'autres esters peuvent être utilisés de la même façon, tels que benzoate, propionate, oléate, stéarate de magnésium.

D'une façon générale, tout ester ou sel de magnésium soluble dans l'alcool ou dans un solvant miscible avec l'alcool, ou encore dans son acide correspondant convient à la réalisation de l'invention:

—soit sous forme de sels minéraux, tels que nitrate ou chlorure de magnésium hydraté ou non en solution alcoolique.

La solution mixte de sels d'aluminium, de magnésium et de silicium est préparée en présence d'un alcool qui peut être par exemple l'isopropanol.

L'hydrolyse qui conduit à la formation du gel s'effectue à une température généralement comprise entre 20°C et 80°C, de préférence entre 20°C et 50°C par une base faible, telle que l'hydrazine hydratée $NH_2$—$NH_2$, $H_2O$. D'une façon générale, toute base faible ne contenant que des ions volatils, telle que l'ammoniaque dilué ou l'hydroxylamine, convient à la réalisation de cette phase du procédé.

On utilise cependant de façon préférentielle l'hydrazine hydratée, car celle-ci joue le rôle de complexant et régule la cinétique d'hydrolyse. Ce rôle exercé par l'hydrazine hydratée sur les cinétiques d'hydrolyse est d'un intérêt tout particulier lorsque l'on utilise comme produits de départ des alcoxydes d'aluminium et de silicium et l'acétate de magnésium, qui ont des cinétiques d'hydrolyse différentes: l'alcoxyde d'aluminium s'hydrolyse facilement, l'alcoxyde de silicium plus difficilement, l'acétate de magnésium de dissout dans l'eau.

Il convient, à ce propos, de noter qu'il est souhaitable que la solution soit totalement exempte d'eau, car la moindre trace d'eau provoquerait une hydrolyse incontrôlée de l'alcoxyde le plus fragile, c'est-à-dire de l'alcoxyde d'aluminium. On note toutefois qui si l'alcoxyde d'aluminium est remplacé par du nitrate d'aluminium, la présence de petites quantités d'eau n'est pas gènante.

Le traitement thermique auquel est soumis le gel après hydrolyse d'effectue à une température au plus égale à 450°C, généralement comprise entre 200°C et 450°C, pendant une durée au plus égale à 24 h, généralement comprise entre 1 et 2 heures, la vitesse de montée en température étant par exemple comprise entre 50°C et 100°C/h. Le but de ce traitement thermique est d'éliminer la plus grande partie des solvants, de l'eau et de l'hydrazine. A l'issue de ce traitement, la poudre obtenue a une couleur blanche ou éventuellement légèrement jaunâtre.

La poudre est éventuellement lavée à l'eau oxygénée de préférence concentrée (20—30%) à une température comprise entre 60°C et 100°C. Ce traitement à l'eau oxygénée a pour but d'éliminer les derniers radicaux organiques pouvant être liés aux métaux Al, Si ou Mg.

On notera que cette étape de traitement à l'eau oxygénée peut être supprimée, si l'application à laquelle la poudre est destinée, n'est pas perturbée par la présence de traces de carbone, résultant de la pyrolyse de matières organiques non totalement éliminées par calcination lors du traitement thermique.

La poudre, après lavage à l'eau oxygénée, est soumise à un nouveau traitement thermique qui s'effectue à une température comprise entre 450°C et 900°C, généralement entre 550°C et 700°C pendant une durée au plus égale à 6 h, généralement comprise entre 30 et 120 min., afin d'éliminer l'eau de constitution et d'hydratation.

La poudre obtenue par le procédé conforme à l'invention a une composition proche de la cordiérite (2 MgO, 2 $Al_2O_3$, 5 $SiO_2$), pouvant être comprise entre les composants de la nappe de cristallisation ternaire:

(60%—50%) $SiO_2$,
(5%—20%) MgO,
(20%—40%) $Al_2O_3$.

Elle à de façon caractéristique une surface spécifique d'au moins 100 $m^2/g$, de préférence d'au moins 250 $m^2/g$, et une température de frittage inférieure à 1100°C.

La poudre obtenue est une poudre relativement grossière qui, après un broyage léger, donne une poudre constituée de grains dont les dimensions sont comprises entre 0,5 µm et 10 µm, et est de couleur blanche.

La poudre conforme à l'invention présente une structure de type verre à très faible degré de cristallinité et reste amorphe jusqu'à une température de l'ordre de 800°C.

La poudre obtenue par le procédé conforme à l'invention présente une excellente aptitude au frittage et se laisse, en particulier, fritter à une température inférieure à 950°C sans adjuvant de frittage, tel que $P_2O_5$.

Après mise en forme par pressage ou encore par coulage à froid, la poudre conforme à l'invention commence à fritter sous forme amorphe à 770°C, pour atteindre un taux de densification d'au moins 95% après 15 min. à 1050°C, la montée en température entre 800°C et 1000°C étant effectuée à une vitesse comprise entre 2°C et 10°C/min.

Lorsque la poudre est mise en forme par coulage à froid, elle est avantageusement mise en suspension dans un solvant tel que méthylcellulose puis appliquée sous la forme d'une pâte homogène sur une surface métallique plane, et ensuite frittée.

En ce que concerne le frittage, on constate en fait que celui-ci procède en trois étapes: frittage sous forme amorphe à partir de 770°C; frittage

sous forme cristallisée à partir de 800°C, la phase cristallisée étant la μ-cordiérite; frittage sous forme cristallisée à partir de 860°C, la phase cristallisée étant un mélange de μ-cordiérite et de β-cordiérite. La transformation complète de la μ-cordiérite en β-cordiérite peut être obtenue à partir de 900°C (les phases μ-cordiérite et β-cordiérite ont été identifiées par leur diffractogramme aux rayons X d'après les fiches ASTM n° 14—249 et 13—293 respectivement).

Le frittage s'accompagne à partir de 800°C de la cristallisation de μ-cordiérite ou du mélange μ-cordiérite-mullite. La céramique obtenue après l'opération de frittage est de la cordiérite forme β quasi pure (2 MgO, 2 $Al_2O_3$, 5 $SiO_2$) ou des mélanges de cordiérite et de mullite (3 $Al_2O_3$, 2 $SiO_3$), la mullite qui peut éventuellement se former étant présente en une quantité comprise entre 5 et 10% au plus.

On notera que la cristallisation de la cordiérite qui accompange le frittage, s'opère sans agent vitrifiant, tel que $P_2O_5$, $B_2O_3$.

Les céramiques obtenues ont une constante diélectrique inférieure à 5.

L'abaissement de la température de frittage obtenu avec les poudres conformes à l'invention est d'un grand intérêt dans de nombreuses applications, en particulier lors de la réalisation de condensateurs multi-couches. Le gain en température est de l'ordre de 300°C à 400°C par rapport à la cordiérite obtenue par les procédés classiques qui fritte à une température de 1300°C—1350°C. Les condensateurs multicouches sont constitués par un empilement de couches de céramique diélectrique alternant avec des couches métalliques constituant les électrodes qui sont confrittées en même temps que les couches céramiques. Compte tenu de la température de frittage élevée 1300°C—1350°C, seuls peuvent convenir les métaux précieux tels que platine, palladium, argent ou or ainsi que leurs alliages.

L'abaissement de la température de frittage obtenu avec les poudres conformes à l'invention permet de remplacer ces métaux par des métaux bon marché.

Il faut, à ce propos, noter que les poudres conformes à l'invention se caractérisent par une très bonne adhésion des encres métalliques Cu, Cu-Ni, Cu-Cr ainsi que des encres à base d'argent ($Pd_{10}$ $Ag_{90}$).

Les condensateurs multi-couches obtenus en utilisant des poudres de composition proche de la cordiérite conformes à l'invention présentent, par ailleurs, de faibles pertes diélectriques et une faible variation capacitive dans le domaine des hautes fréquences (100 MHz ou 10 GHz), la tangente de l'angle de perte de ces condensateurs est de l'ordre de $15 \cdot 10^{-4}$ à 1 MHZ.

La poudre conforme à l'invention peut recevoir de nombreuses autres applications. Parmi cellesci, on peut citer:

—la fabrication de substrats isolants et de supports pour la multi-connexion des circuits intégrés,

—la protection des surfaces métalliques.

Grâce à leur excellente aptitude au couchage, les poudres conformes à l'invention mises en suspension dans un solvant sont appliquées sous la forme d'une mince couche sur la surface à revêtir et sont ensuite frittées à basse température.

—la fabrication de céramiques poreuses.

La présence d'une faible quantité de carbone dans la poudre après traitement thermique est dans ce cas recherchée. Une telle céramique est obtenue en supprimant l'étape de traitement à l'eau oxygénée dont on a vu qu'elle avait pour but d'éliminer totalement les radicaux organiques pouvant être liés aux métaux Al, Si, Mg.

—la fabrication de fibres céramiques présentant un coefficient d'expansion très faible (de l'ordre de $2 \cdot 10^{-6}C^{-1}$),

—la fabrication de céramiques structurales de bonnes propriétés thermo-mécaniques,

—les supports de catalyseurs.

D'autres particularités et avantages de l'invention apparaîtront à la lecture des exemples de réalisation donnés, ci-après, à titre non limitatif.

Exemple 1

On dissout 4,74 g de butoxyde d'aluminium et 4,858 g d'éthoxyde de silicium dans 30 ml d'isopropanol.

On dissout ensuite 1, 301 g d'acétate de magnésium préalablement séché à l'étuve à une température comprise entre 100 et 150°C dans 15 ml d'acide acétique anhydre.

On mélange les deux solutions et on obtient ainsi une solution limpide.

On introduit dans cette solution un volume de 30 ml d'hydrate d'hydrazine sous agitation vigoureuse. Il se forme un gel qu'on laisse reposer quelques heures.

Le gel est soumis à un traitement thermiques avec une vitesse de montée en température de 200°C à 450°C/h et un palier de 1 à 3 h à une température de 200°C à 450°C.

Le gel est ensuite lavé à l'eau oxygénée concentrée. La poudre obtenue après filtration est portée à 700°C pendant 1/2 à 2 h.

Une analyse aux rayons X montre que cette poudre a une structure de type verre à très faible degré de cristallinité. Sa composition est celle de la cordiérite (2 MgO, 2 $Al_2O_3$, 5 $SiO_2$).

La poudre pressée (3 t/cm$^2$) sous forme d'un parallélépipède, montre un début de frittage entre 820°C—830°C pour se terminer à 1050°C. La densité obtenue est supérieure à 96% de la valeur théorique. La constante diélectrique est de 4 (à titre indicatif, les meilleures valeurs qui ont été obtenues jusqu'ici ne sont pas inférieures à 4,9). Le coefficient d'expansion est de l'ordre de $2 \cdot 10^{-6}C^{-1}$.

La surface spécifique ("BET") mesurée pour la poudre ainsi obtenue est supérieure à 270 m$^2$/g, soit de plus d'un ordre de grandeur supérieure aux valeurs relevées pour des cordiérites classiques, de l'ordre de 10 m$^2$/g.

Le cliché de diffraction aux rayons X établi pour

cette poudre, après traitement thermique de 1 h, reste blanc poure des températures allant de la température ambiante jusqu'à 800°C, révélant l'absence de structure cristalline.

L'analyse quantitative montre également une pureté supérieure à 99%, soit un taux de cations (autres que Si, Al ou Mg) inférieur à 1%. On peut noter en particulier l'absence totale de $TiO_2$ et $P_2O_5$, alors que ces oxydes sont toujours présents, au moins à l'état de traces, dans les poudres de cordiérite préparées classiquement par une méthode verrière.

Le procédé de cristallisation de la poudre amorphe peut se caractériser par une étude de diffraction aux rayons X à haute température entre 500°C et 1100°C.

Ce cliché, effectué sur une poudre préparée à 500°C selon le procédé décrit plus haut, montre l'apparition entre 780°C et 830°C d'un composé cristallisé dont le système de raies de diffraction est caractéristique de la μ-cordiérite, la β-cordiérite n'apparaît qu'à 890°C.

Exemple 2

On réalise une céramique à partir d'une poudre dont on a fait varier la composition en magnésium de +10% par rapport à la valeur stoechiométrique.

On remplace, à cet effet, dans l'exemple 1 les 1,301 g d'acétate de magnésium par 1,430 g d'acétate de magnésium, les autres valeurs restant inchangées. Les conditions opératoires sont les mêmes que dans l'exemple 1.

On observe un début de frittage à 800°C—850°C et une fin de frittage vers 1050°C.

La céramique obtenue est constituée essentiellement de cordiérite (2 MgO, 2 $Al_2O_3$, 5 $SiO_2$). Elle a une densité d'environ 95% de la valeur théorique.

**Revendications**

1. Procédé de préparation d'une poudre céramique frittable de type cordiérite, caractérisé en ce qu'il consiste successivement:

—à préparer une solution alcoolique mixte de sels de magnésium, d'aluminium et de silicium, lesdits sels devant être solubles dans l'alcool ou dans un solvant miscible avec l'alcool,

—à réaliser une agitation vigoureuse pour obtenir une solution homogène,

—à ajouter à la solution précédente un agent hydrolysant sous forme de base faible totalement volatile, ce qui conduit à la formation d'un gel,

—à traiter thermiquement le gel obtenu à une température au plus égale à 450°C pendant une durée au plus égale à 24 h, ce qui conduit à la formation d'une poudre,

—à traiter thermiquement la poudre obtenue à une température comprise entre 450°C et 900°C pendant une durée au plus égale à 6 h.

2. Procédé selon la revendication 1, caractérisé en ce que l'étape de traitement thermique de la poudre est précédée d'une étape de traitement par de l'eau oxygénée à une température comprise entre 60°C et 100°C, puis de filtrage de la suspension obtenue.

3. Procédé selon la revendication 2, caractérisé en ce que l'aluminium est introduit sous forme d'un alcoxyde soluble dans l'alcool de formule

$$Al[O(CH_2)_nCH_3]_3$$

dans laquelle n représente un nombre entier compris entre 0 et 4.

4. Procédé selon la revendication 3, caractérisé en ce que l'alcoxyde d'aluminium est le butoxyde d'aluminium.

5. Procédé selon la revendication 4, caractérisé en ce que l'aluminium est introduit sous forme de sels organiques ou de complexes organiques solubles dans l'alcool ou solubles dans un solvant miscible avec l'alcool.

6. Procédé selon la revendication 5, caractérisé en ce que le sel organique ou le complexe organique est choisi dans le groupe constitué par l'acétate, le benzoate, l'acétylacétonate, le stéarate d'aluminium.

7. Procédé selon la revendication 1, caractérisé en ce que l'aluminium est introduit sous forme de sels minéraux solubles dans l'alcool ou dans un solvant miscible avec l'alcool.

8. Procédé selon la revendication 7, caractérisé en ce que les sels minéraux sont choisis dans le groupe constitué par le nitrate d'aluminium hydraté ou non, le chlorure d'aluminium hydraté ou non.

9. Procédé selon la revendication 1, caractérisé en ce que le silicium est introduit sous forme d'un alcoxyde de formule

$$Si[O(CH_2)_nCH_3]_4$$

dans laquelle n représente un nombre entier compris entre 0 et 4.

10. Procédé selon la revendication 9, caractérisé en ce que l'alcoxyde de silicium est l'éthoxyde de silicium.

11. Procédé selon la revendication 1, caractérisé en ce que le silicium est introduit sous forme d'esters ou de sels solubles dans l'alcool ou solubles dans un solvant miscible avec l'alcool.

12. Procédé selon la revendication 11, caractérisé en ce que l'ester est choisi dans le groupe comprenant le tétracétate de silicium et les silicates d'ammonium quaternaires.

13. Procédé selon la revendication 1, caractérisé en ce que le magnésium est introduit sous forme d'un ester ou d'un sel soluble dans l'alcool ou dans un solvant miscible avec l'alcool ou encore dans son acide correspondant.

14. Procédé selon la revendication 1, caractérisé en ce que le magnésium est introduit sous forme de sels minéraux solubles dans l'alcool ou dans un solvant miscible avec l'alcool.

15. Procédé selon la revendication 14, caractérisé en ce que le sel minéral est constitué par le nitrate ou chlorure de magnésium hydraté ou non.

16. Procédé selon la revendication 1, caractérisé

en ce que la solution mixte de sels d'aluminium et de silicium est préparée en présence d'isopropanol.

17. Procédé selon la revendication 1, caractérisé en ce que l'hydrolyse est effectuée à une température comprise entre 20°C et 80°C.

18. Poudre céramique frittable de type cordiérite, obtenue par le procédé selon l'une des revendications 1 à 17, caractérisée en ce que sa composition est 60 à 50% $SiO_2$, 5 à 20% MgO et 20 à 40% $Al_2O_3$, et en ce que sa surface spécifique est au moins égale à 100 $m^2/g$, cette poudre ayant une température de frittage inférieure à 1100°C.

19. Poudre selon la revendication 18, caractérisée en ce que sa surface spécifique est au moins égale à 250 $m^2/g$.

20. Poudre selon la revendication 18 ou 19, caractérisée en ce qu'elle présente une granulométrie comprise entre 0,5 et 10 µm et en ce qu'elle a une structure de type verre à très faible degré de cristallinité.

21. Composition céramique, selon l'une des revendications 18 à 20 est obtenue par frittage d'une poudre selon l'une des revendications 18 à 20.

22. Composition céramique selon la revendication 21, caractérisée en ce que le frittage est effectué à une température comprise entre 800°C et 1050°C, avec une vitesse de montée en température comprise entre 2 et 10°C/min. et par maintien pendant environ 15 min. à une température de l'ordre de 1 000°C.

23. Composition céramique selon l'une des revendications 21 et 22, caractérisée en ce que sa composition est celle de la cordiérite (2 MgO, 2 $Al_2O_3$, 3 $SiO_2$), en ce que sa densité est au moins égale à 95% de la densitè théorique et en ce qu'elle a une constante diélectrique inférieure à 5.

**Patentansprüche**

1. Verfahren zur Herstellung eines sinterbaren keramischen Cordierit-Pulvers, dadurch gekennzeichnet, daß es darin besteht, nacheinander:

—eine gemischte alkoholische Lösung von Magnesium-, Aluminium- und Siliciumsalzen herzustellen, wobei besagte Salze in dem Alkohol oder in einem mit dem Alkohol mischbaren Lösungsmittel löslich sein müssen,

—ein kräftiges Umrühren durchzuführen, um eine homogene Lösung zu erhalten,

—der vorangehenden Lösung ein Hydrolysierungsmittel in Form einer schwachen, vollständig flüchtigen Base zuzusetzen, was zur Bildung eines Gels führt,

—das erhaltene Gel bei einer Temperatur von höchstens 450°C während einer Zeitdauer von höchstens 24 h thermisch zu behandeln, was zur Bildung eines Pulvers führt,

—das erhaltene Pulver bei einer Temperatur zwischen 450°C und 900°C während einer Zeitdauer von höchstens 6 h thermisch zu behandeln.

2. Verfahren nach Anspruch 1, dadurch gekennzeichnet, daß dem Schritt der thermischen Behandlung des Pulvers ein Behandlungsschritt mit sauerstoffangereichertem Wasser bei einer Temperatur zwischen 60°C und 100°C vorangeht, gefolgt von der Filtration der erhaltenen Suspension.

3. Verfahren nach Anspruch 2, dadurch gekennzeichnet, daß das Aluminium in Form eines in dem Alkohol löslichen Alkoholats der Formel

$$Al[O(CH_2)_nCH_3]_3,$$

in der n eine ganze Zahl zwischen 0 und 4 darstellt, eingebracht wird.

4. Verfahren nach Anspruch 3, dadurch gekennzeichnet, daß das Aluminiumalkoholat Aluminiumbutanolat ist.

5. Verfahren nach Anspruch 4, dadurch gekennzeichnet, daß das Aluminium in Form organischer Salze oder organischer Komplexe eingebracht wird, die in dem Alkohol oder in einem mit dem Alkohol mischbaren Lösungsmittel löslich sind.

6. Verfahren nach Anspruch 5, dadurch gekennzeichnet, daß das organische Salz oder der organische Komplex ausgewählt wird aus der Gruppe, die aus Aluminiumacetate, -benzoat, -acetylacetonat, -stearat besteht.

7. Verfahren nach Anspruch 1, dadurch gekennzeichnet, daß das Aluminium in Form von in dem Alkohol oder in einem mit dem Alkohol mischbaren Lösungsmittel löslichen Mineralsalzen eingebracht wird.

8. Verfahren nach Anspruch 7, dadurch gekennzeichnet, daß die Mineralsalze ausgewählt werden aus der Gruppe, die aus dem hydratisierten oder nicht-hydratisierten Aluminiumnitrat, den hydratisierten oder nicht-hydratisierten Aluminiumchlorid besteht.

9. Verfahren nach Anspruch 1, dadurch gekennzeichnet, daß das Silicium in Form eines Alkoholats der Formel

$$Si[O(CH_2)_nCH_3]_4,$$

in der n eine ganze Zahl zwischen 0 und 4 darstellt, eingebracht wird.

10. Verfahren nach Anspruch 9, dadurch gekennzeichnet, daß das Siliciumalkoholat Siliciumethanolat ist.

11. Verfahren nach Anspruch 1, dadurch gekennzeichnet, daß das Silicium in Form von in dem Alkohol oder in einem mit dem Alkohol mischbaren Lösungsmittel löslichen Estern oder Salzen eingebracht wird.

12. Verfahren nach Anspruch 11, dadurch gekennzeichnet, daß der Ester ausgewählt wird aus der Gruppe, die Siliciumtetraacetat und quaternäre Ammoniumsilikate umfaßt.

13. Verfahren nach Anspruch 1, dadurch gekennzeichnet, daß das Magnesium in Form eines in dem Alkohol oder in einem mit dem Alkohol mischbaren Lösungsmittel oder auch in seiner entsprechenden Säure löslichen Esters oder Salzes eingebracht wird.

14. Verfahren nach Anspruch 1, dadurch gekennzeichnet, daß das Magnesium in Form von in dem Alkohol oder in einem mit dem Alkohol

mischbaren Lösungsmittel löslichen Mineralsalzen eingebracht wird.

15. Verfahren nach Anspruch 14, dadurch gekennzeichnet, daß das Mineralsalz durch hydratisiertes oder nicht-hydratisiertes Magnesiumnitrat oder -chlorid dargestellt wird.

16. Verfahren nach Anspruch 1, dadurch gekennzeichnet, daß die gemischte Lösung von Aluminium- und Siliciumsalzen in Gegenwart von Isopropanol hergestellt wird.

17. Verfahren nach Anspruch 1, dadurch gekennzeichnet, daß die Hydrolyse bei einer Temperatur zwischen 20°C und 80°C durchgeführt wird.

18. Sinterbares keramisches Cordierit-Pulver, erhalten nach dem Verfahren nach einem der Ansprüche 1 bis 17, dadurch gekennzeichnet, daß seine Zusammensetzung 60 bis 50% $SiO_2$, 5 bis 20% MgO und 20 bis 40% $Al_2O_3$ ist und daß seine spezifische Oberfläche wenigstens 100 $m^2/g$ ist, wobei dieses Pulver eine Syntertemperatur unterhalb von 1100°C besitzt.

19. Pulver nach Anspruch 18, dadurch gekennzeichnet, daß seine spezifische Oberfläche wenigstens 250 $m^2/g$ ist.

20. Pulver nach Anspruch 18 oder 19, dadurch gekennzeichnet, daß es eine Kornklassierung zwischen 0,5 und 10 µm zeigt und daß es eine Glasstruktur mit sehr schwachem Kristallinitätsgrad besitzt.

21. Keramische Zusammensetzung, erhalten durch Sinterung eines Pulvers nach einem der Ansprüche 18 bis 20.

22. Keramische Zusammensetzung nach Anspruch 21, dadurch gekennzeichnet, daß die Sinterung bei einer Temperatur zwischen 800°C und 1050°C durchgeführt wird, mit einer Geschwindigkeit des Temperaturanstiegs zwischen 2 und 10°C/min und durch Halten während ungefähr 15 min bei einer Temperatur in der Größenordnung von 1000°C.

23. Keramische Zusammensetzung nach einem der Ansprüche 21 und 22, dadurch gekennzeichnet, daß seine Zusammensetzung diejenige des Cordierits ist (2 MgO, 2 $Al_2O_3$, 3 $SiO_2$), daß seine Dichte wenigstens 95% der theoretischen Dichte ist und daß sie eine dielektrische Konstante unterhalb von 5 besitzt.

## Claims

1. A process for the preparation of a cordierite type sinterable ceramic powder, characterized in that it consists successively:

in preparing a mixed alcoholic solution of magnesium, aluminium and silicon salts, it being required that the said salts are soluble in alcohol or in a solvent which is miscible with alcohol,

in performing a vigorous stirring in order to obtain a homogeneous solution,

in adding a hydrolyzing agent in the form of a totally volatile weak base to the previous solution, which leads to the formation of a gel,

in treating thermally the gel obtained at a temperature not exceeding 450°C for a period not exceeding 24 h, which leads to the formation of a powder,

in treating thermally the powder obtained at a temperature of between 450°C and 900°C for a period not exceeding 6 h.

2. The process as claimed in claim 1, characterized in that the stage of the thermal treatment of the powder is preceded by a hydrogen peroxide treatment stage at a temperature of between 60°C and 100°C, followed by filtration of the suspension obtained.

3. The process as claimed in claim 2, characterized in that the aluminum is introduced in the form of an alcohol-soluble alkoxide of formula

$$Al[O(CH_2)_nCH_3]_3$$

in which n represents an integer of between 0 and 4.

4. The process as claimed in claim 3, characterized in that the aluminum alkoxide is aluminum butoxide.

5. The process as claimed in claim 4, characterized in that the aluminum is introduced in the form of organic salts or of organic complexes which are soluble in alcohol or are soluble in a solvent which is miscible with alcohol.

6. The process as claimed in claim 5, characterized in that the organic salt or the organic complex is chosen from the group consisting of aluminium acetate, benzoate, acetylacetonate, stearate.

7. The process as claimed in claim 1, characterized in that the aluminium is introduced in the form of inorganic salts which are soluble in alcohol or in a solvent which is miscible with alcohol.

8. The process as claimed in claim 7, characterized in that the inorganic salts are chosed from the group consisting of anhydrous or hydrated aluminium nitrate, anhydrous or hydrated aluminium chloride.

9. The process as claimed in claim 1, characterized in that the silicon is introduced in the form of an alkoxide of formula

$$Si[O(CH_2)_nCH_3]_4$$

in which n represents an integer of between 0 and 4.

10. The process as claimed in claim 9, characterized in that the silicon alkoxide is silicon ethoxide.

11. The process as claimed in claim 1, characterized in that the silicon is introduced in the form of esters or salts which are soluble in alcohol or are soluble in a solvent which is miscible with alcohol.

12. The process as claimed in claim 11, characterized in that the ester is chosen from the group consisting of silicon tetraacetate and quaternary ammonium silicates.

13. The process as claimed in claim 1, characterized in that the magnesium is introduced in the form of an ester or a salt which is soluble in

alcohol or in a solvent which is miscible with alcohol or alternatively, in its corresponding acid.

14. The process as claimed in claim 1, characterized in that the magnesium is introduced in the form of inorganic salts which are soluble in alcohol or in a solvent which is miscible with alcohol.

15. The process as claimed in claim 14, characterized in that the inorganic salt consists of anhydrous or hydrated magnesium nitrate or chloride.

16. The process as claimed in claim 1, characterized in that the mixed solution of aluminum and silicon salts is prepared in the presence of isopropanol.

17. The process as claimed in claim 1, characterized in that the hydrolysis is carried out at a temperature of between 20°C and 80°C.

18. A cordierite type sinterable ceramic powder, which is produced by the process as claimed in one of claims 1 to 17, characterized in that its composition is: 60 to 50% $SiO_2$, 5 to 20% MgO and 20 to 40% $Al_2O_3$, and in that its specific surface area is not less than 100 $m^2/g$, this powder having a sintering temperature lower that 1,100°C.

19. The powder as claimed in claim 18, characterized in that its specific surface area is not less than 250 $m^2/g$.

20. The powder as claimed in claim 18 or 19, characterized in that it has a particle size of between 0.5 and 10 µm and in that it has a very weakly crystalline glass type structure.

21. A ceramic composition, which is produced by sintering a powder as claimed in one of claims 18 to 20.

22. The ceramic composition as claimed in claim 21, characterized in that the sintering is carried out at a temperature of between 800°C and 1,050°C, with a rate of increase in temperature of between 2 and 10°C/min and by maintaining at a temperature of the order of 1,000°C for approximately 15 min.

23. The ceramic composition as claimed in one of claims 21 and 22, characterized in that its composition is that of cordierite ($2MgO$, $2Al_2O_3$, $3SiO_2$), in that its density is not less than 95% of the theoretical density and in that it has a dielectric constant less than 5.